# EUROPEAN PATENT APPLICATION

(11) **EP 4 586 419 A1**
(43) Date of publication of application: **16.07.2025**
(21) Application number: 23863065.1
(22) Date of filing: 30.08.2023
(51) Int. Cl.: H01S 1/06, B81B 1/00, H03L 7/26

(54) **METAL GAS SEALED CELL**

(30) Priority: 09.09.2022 JP 2022143731
(71) Applicant: Kyoto University, Kyoto-shi, Kyoto 606-8501 (JP)
(72) Inventor: HIRAI, Yoshikazu, Kyoto-shi, Kyoto 606-8501 (JP); KIYOSE, Shun, Kyoto-shi, Kyoto 606-8501 (JP)
(74) Representative: Cabinet Beau de Loménie
(86) International application number: PCT/JP2023/031643
(87) International publication number: WO 2024/053527

(57) **Abstract**

A metal-vapor-filled cell 100 includes: a cell main body 10; a glass sheet 11; an optical chamber 14 provided in at least one selected from the cell main body 10 and the glass sheet 11, the optical chamber 14 communicating with a vapor generating portion 20; and a metal vapor filling the optical chamber 14. The vapor generating portion 20 and the optical chamber 14 communicate with each other. The vapor generating portion 20 includes a plurality of pillars 24, a plurality of bottomed grooves 22 provided between the plurality of pillars 24 and open to a first surface 10p, and an introduction port 26 for introducing a raw material solution 34a of the metal vapor into the plurality of bottomed grooves 22. The introduction port 26 includes at least one of a structure lacking a portion of at least one pillar 24 selected from the plurality of pillars 24 and a structure lacking the entirety of at least one pillar 24 selected from the plurality of pillars 24.

## Description

### TECHNICAL FIELD

The present disclosure relates to a metal-vapor-filled cell.

### BACKGROUND ART

Research and development have been advanced around the world in relation to the miniaturization of various atomic sensor devices such as atomic clocks capable of achieving high-precision time synchronization and atomic magnetic sensors measuring the biomagnetism with high sensitivity. For example, an achievement in miniaturization of atomic clocks by Micro Electro Mechanical Systems (MEMS) technique would make it possible to replace existing crystal oscillators with atomic clocks. Atomic clocks are also expected to be used in various devices such as smartphones and microsatellites.

An atomic clock has, as its main component, an alkali-vapor-filled cell in which a container is filled with an alkali metal vapor and a buffer gas. In the case where ¹³³Cs is used as the alkali metal, it is possible to achieve an atomic clock having high precision as well as being miniature and power saving by using the coherent population trapping (CPT) resonance, which is a quantum interference effect that appears in the two-photon transitions between the ground-state hyperfine levels of Cs. One of the important indices indicating the performance of an atomic clock is the frequency stability. The frequency stability is evaluated separately in terms of short-term stability and long-term stability. The short-term stability is theoretically determined by the product of the Q value of the CPT resonance and the S/N ratio. The long-term stability is evaluated by, for example, the phenomenon in which the frequency varies due to the changes over time in both light quantity of the semiconductor laser for excitation, and partial pressure of the buffer gas inside the vapor-filled cell. For this reason, to enhance the performance of the atomic clock, a technique for producing a vapor-filled cell is important.

Patent Literature 1 describes an example of conventional vapor-filled cells. The alkali metal cell described in Patent Literature 1 includes a member made of Si having a cell internal portion, a pair of glass sheets bonded to both the surfaces of the member made of Si, and an alkali metal raw material disposed inside the cell internal portion. The alkali metal raw material is solid CsN₃. Irradiating CsN₃ with UV light or laser light generates Cs vapor and N₂.

The method for generating Cs vapor using a decomposition reaction of CsN₃ has the advantage of being capable of generating high-purity Cs vapor, thereby enabling the fabrication of high-quality vapor cells. However, it is not easy to efficiently generate Cs vapor from solid CsN₃. For example, when CsN₃ is heated in a high vacuum and the temperature of CsN₃ thus reaches its melting point, 310°C, or higher, CsN₃ causes a decomposition reaction along with scattering. Accordingly, even when solid CsN₃ is heated at a high temperature, 600°C or higher and 700°C or lower, the Cs generation amount necessary for achieving the CPT resonance cannot be obtained. For this reason, it is usually necessary to generate Cs vapor slowly (for example, over 24 hours) by UV light irradiation.

Patent Literature 2 describes a structure for efficient generation of Cs vapor in a short time. The metal-vapor-filled cell described in Patent Literature 2 has a basic structure in which a cell main body made of Si is sandwiched between two glass sheets, and has characteristics such as the generation of a solid raw material of a metal vapor from a raw material solution of the metal vapor and the capability of generating a metal vapor from a solid raw material by relatively low-temperature processing.

### CITATION LIST

### Patent Literature

Patent Literature 1: JP 2013-38382 A
Patent Literature 2: WO 2022/097557

### SUMMARY OF INVENTION

### Technical Problem

The metal-vapor-filled cell described in Patent Literature 2 includes an injection port for supplying a raw material solution of a metal vapor to the vapor generating portion of the cell main body. The injection port becomes a dead space after the completion of the metal-vapor-filled cell, and thus hinders the miniaturization of the metal-vapor-filled cell. It is also conceivable that the injection port is omitted and the raw material solution is injected directly into the grooves of the vapor generating portion. In this case, however, the surface of the cell main body becomes contaminated, which may interfere with the bonding between the cell main body and the glass sheets. Insufficient bonding between the cell main body and the glass sheets results in a significant decrease in the metal vapor density and significant fluctuations in the vapor pressure over time in the optical chamber, thereby compromising the stability of the performance of the metal-vapor-filled cell. Further, adherence of the raw material solution of the metal vapor to the inner surfaces of the glass sheets that close the optical chamber can interfere with the laser beam, thereby also affecting the performance of the metal-vapor-filled cell. To avoid such issues, a dedicated injection port has conventionally been considered required for isolating the injection position of the raw material solution of a metal vapor from the optical chamber and the vapor generating portion.

The present invention aims to provide a technique for improving the stability of the performance of a metal-vapor-filled cell while achieving the miniaturization thereof.

### Solution to Problem

The present invention provides a metal-vapor-filled cell including:
a cell main body including a first surface and a vapor generating portion;
a glass sheet bonded to the first surface of the cell main body;
an optical chamber provided in at least one selected from the cell main body and the glass sheet, the optical chamber communicating with the vapor generating portion; and
a metal vapor filling the optical chamber, wherein
the vapor generating portion includes a plurality of pillars, a plurality of bottomed grooves provided between the plurality of pillars and open to the first surface, and an introduction port for introducing a raw material solution of the metal vapor into the plurality of bottomed grooves, and
the introduction port includes at least one of a structure lacking a portion of at least one pillar selected from the plurality of pillars and a structure lacking the entirety of at least one pillar selected from the plurality of pillars.

### Advantageous Effects of Invention

According to the present invention, it is possible to provide a technique for improving the stability of the performance of a metal-vapor-filled cell while achieving the miniaturization thereof.

### BRIEF DESCRIPTION OF DRAWINGS

FIG. 1 is a perspective view of a metal-vapor-filled cell according to an embodiment of the present invention.
FIG. 2 is a plan view of the cell main body of the metal-vapor-filled cell shown in FIG. 1.
FIG. 3A is a cross-sectional view of the cell main body taken along line IIIA-IIIA shown in FIG. 2.
FIG. 3B is a cross-sectional view of the cell main body taken along line IIIB-IIIB shown in FIG. 2.
FIG. 4 is a process diagram showing a method for manufacturing the metal-vapor-filled cell.
FIG. 5A is a view illustrating a method for fabricating an introduction port.
FIG. 5B is a view illustrating the method for fabricating the introduction port.
FIG. 6 is a plan view and a cross-sectional view, both illustrating another method for fabricating the introduction port.
FIG. 7 is a plan view of a vapor generating portion according to Modification 1.
FIG. 8A is a cross-sectional view of a metal-vapor-filled cell using a cell main body according to Modification 2.
FIG. 8B is a plan view of the cell main body according to Modification 2.
FIG. 9 is a plan view of a vapor generating portion according to Modification 3.

### DESCRIPTION OF EMBODIMENTS

Embodiments of the present invention will be described below with reference to the drawings. The present invention is not limited to the following embodiments.

### (Embodiment)

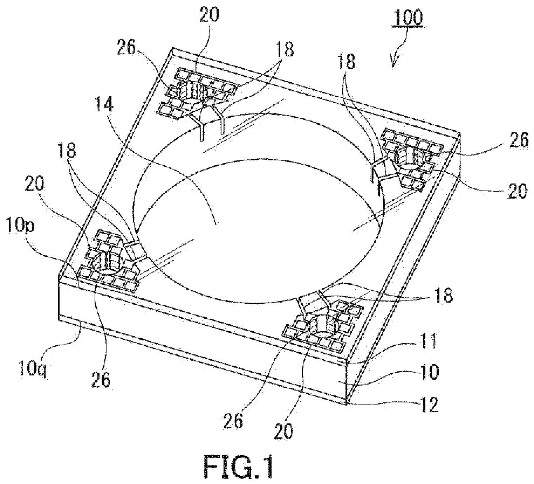

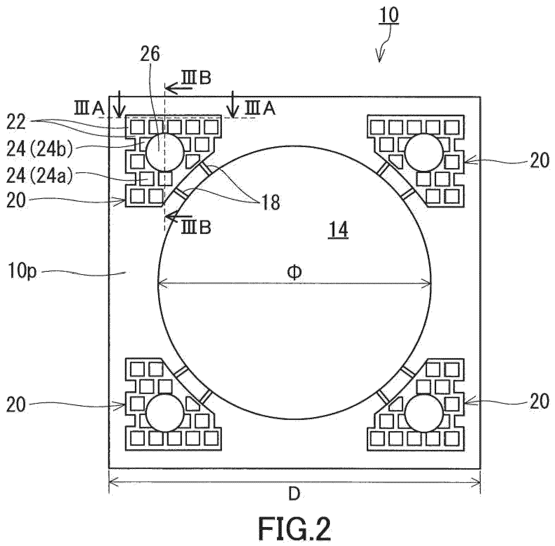

FIG. 1 is a perspective view of a metal-vapor-filled cell 100 according to an embodiment of the present invention. FIG. 2 is a plan view of a cell main body 10 of the metal-vapor-filled cell 100 shown in FIG. 1. The metal-vapor-filled cell 100 includes the cell main body 10, a first glass sheet 11, and a second glass sheet 12. The cell main body 10 has a first surface 10p and a second surface 10q. The first surface 10p and the second surface 10q are surfaces facing each other. The first surface 10p and the second surface 10q each may be the principal surface of the cell main body 10. The "principal surface" means the surface having the largest area. The first glass sheet 11 is bonded to the first surface 10p. The second glass sheet 12 is bonded to the second surface 10q.

In the present embodiment, the first glass sheet 11 entirely covers the first surface 10p, and the second glass sheet 12 entirely covers the second surface 10q. However, this is not required. The first surface 10p may include a portion that is not covered with the first glass sheet 11. The second surface 10q may include a portion that is not covered with the second glass sheet 12.

The inside of the metal-vapor-filled cell 100 is filled with a metal vapor and a buffer gas. The metal vapor typically includes an atomic alkali metal vapor such as K vapor, Rb vapor, or Cs vapor. Owing to the filling with the alkali metal vapor, it is possible to cause the metal-vapor-filled cell 100 to function as the atomic oscillator by detecting the CPT resonance. An example of the buffer gas is an inert gas. Examples of the inert gas include H₂ gas, N₂ gas, a noble gas, and a mixed gas thereof. The buffer gas is not required, and the metal-vapor-filled cell 100 may be filled with only the metal vapor.

The first glass sheet 11 and the second glass sheet 12 are each a thin glass sheet that sufficiently transmits light in a predetermined wavelength band. "Light in a predetermined wavelength band" means light to be emitted in actually using the metal-vapor-filled cell 100. For example, when the metal vapor is Cs vapor, light in a predetermined wavelength band is light in the absorption wavelength band of Cs (e.g., for the Cs-D1 line, 894.6 nm). "Sufficiently transmitting" means, for example, that the transmittance of light in a predetermined wavelength band is 90% or higher. A glass sheet that is anodically bondable to the cell main body 10 can be used as the first glass sheet 11 and the second glass sheet 12. Examples of glass that is anodically bondable to silicon include silicate glass, borosilicate glass, aluminosilicate glass, and aluminoborosilicate glass.

The cell main body 10 is made of, for example, silicon. By using the MEMS fabrication technique, the plurality of metal-vapor-filled cells 100 can be manufactured from one silicon wafer at the wafer level. Silicon is less subject to a reaction with an alkali metal vapor and a buffer gas. Accordingly, in the case where the cell main body 10 is made of silicon, the internal atmosphere of the metal-vapor-filled cell 100 can be kept stable and the vapor pressure of the alkali metal vapor can be kept constant. Using a high-quality silicon wafer can promise to enhance the performance of the metal-vapor-filled cell 100 as well. Further, in the case where the cell main body 10 is made of silicon, the first glass sheet 11 and the second glass sheet 12 can be bonded to the cell main body 10 by anodic bonding without using any other bonding material. This also contributes to keeping the internal atmosphere of the metal-vapor-filled cell 100 stable and keeping the vapor pressure of the alkali metal vapor constant. However, the material of the cell main body 10 is not particularly limited. The cell main body 10 may be made of a metal such as stainless steel or glass as long as the material can be subjected to micromachining. The shape of the cell main body 10 is not particularly limited either. The cell main body 10 may have the shape of a plate, a circular column, or a rectangular parallelepiped. The cell main body 10 having a rectangular parallelepiped shape means that a polyhedron surrounding the cell main body 10 and having the minimum volume is a rectangular parallelepiped. The method for bonding the first glass sheet 11 and the second glass sheet 12 to the cell main body 10 is not particularly limited either. At least one of the first glass sheet 11 and the second glass sheet 12 may be bonded to the cell main body 10 by using a bonding material such as an adhesive agent, a glass frit, or a metal material. The method for bonding the cell main body 10 and the first glass sheet 11 to each other may be different from the method for bonding the cell main body 10 and the second glass sheet 12 to each other.

The cell main body 10 has an optical chamber 14 and at least one vapor generating portion 20. The optical chamber 14 may be provided in the first glass sheet 11 and/or the second glass sheet 12. The optical chamber 14 can be a portion that is provided in at least one selected from the cell main body 10, the first glass sheet 11, and the second glass sheet 12, and that communicates with the vapor generating portion 20.

The optical chamber 14 is a portion filled with the metal vapor and is the light path for detecting the CPT resonance. In the case where the optical chamber 14 is provided in the cell main body 10 as shown in FIG. 1, the optical chamber 14 is open to at least one of the first surface 10p and the second surface 10q. In the present embodiment, the optical chamber 14 includes a through hole extending through the cell main body 10 from the first surface 10p to the second surface 10q. The cross-sectional area of the through hole may be constant or vary in the thickness direction of the cell main body 10. In the example in FIG. 1, the through hole serving as the optical chamber 14 is positioned at the center of the cell main body 10. Alternatively, it is also possible to use, as the optical chamber, a bottomed hole that is open to only the first surface 10p or the second surface 10q. The shape of the optical chamber 14 is not particularly limited. The optical chamber 14 may have the shape of a circle, an ellipse, or a polygon in plan view. The position of the optical chamber 14 is not particularly limited either, and the optical chamber may be provided at a position deviated from the center of the cell main body 10. As a method for fabricating the optical chamber in the first glass sheet 11, a method for forming a recess in the first glass sheet 11 by ion etching or other methods, a method for shaping the first glass sheet 11 itself into a domed form, and the like can be employed.

In the present embodiment, no through hole is present in the cell main body 10 other than the through hole serving as the optical chamber 14. According to such a configuration, the second glass sheet 12 can be more firmly bonded to the second surface 10q of the cell main body 10. Consequently, the stability of the performance of the metal-vapor-filled cell 100 is improved. However, the optical chamber 14 may be a bottomed hole. In this case, the second glass sheet 12 can be omitted.

The vapor generating portion 20 is a portion for generating the solid raw material of the metal vapor from the raw material solution of the metal vapor and generating the metal vapor from the solid raw material. The vapor generating portion 20 includes a plurality of grooves 22, a plurality of pillars 24, and an introduction port 26. The plurality of grooves 22 are provided between the plurality of pillars 24 and are open to the first surface 10p. The plurality of grooves 22 are bottomed grooves. The plurality of grooves 22 extend in a grid pattern in plan view so that the vapor generating portion 20 has the plurality of pillars 24. In the example in FIG. 1, the plurality of grooves 22 are fabricated so that the plurality of pillars 24 are arranged in a staggered pattern. According to such a fine structure, it is possible to sufficiently ensure the area of the surface on which the solid raw material of the metal vapor is to be deposited. The pillar 24 has a rectangular (typically square) shape in plan view. However, the shape of the pillar 24 is not particularly limited. The pillar 24 may have the shape of a rectangular column or a circular column.

When the cell main body 10 is square, a length D of one side thereof is, for example, 2 mm or more and 8 mm or less. When the optical chamber 14 has a circular shape in plan view, its diameter Φ is, for example, 1 mm or more and 6 mm or less.

A microchannel 18 is provided between the optical chamber 14 and the vapor generating portion 20 to allow them to communicate with each other. In the present embodiment, a plurality of grooves that are open to the first surface 10p each serve as the microchannel 18. The groove serving as the microchannel 18 has a width that is, for example, smaller than the width of the groove 22 in the vapor generating portion 20. Such a structure helps to hinder the solid raw material or raw material solution of the metal vapor from being introduced into the optical chamber 14. The groove serving as the microchannel 18 has a width of, for example, 1 µm or more and 30 µm or less. The microchannel 18 may be defined by only one groove.

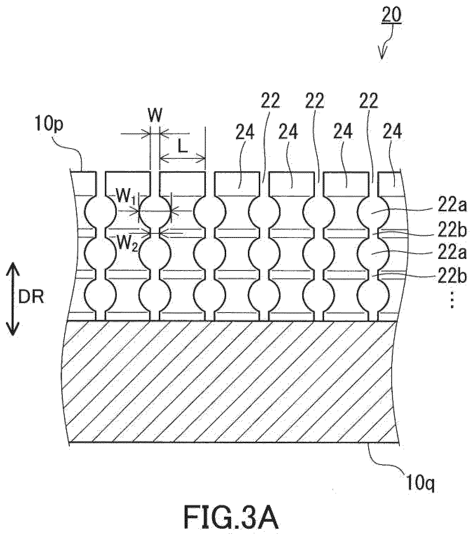

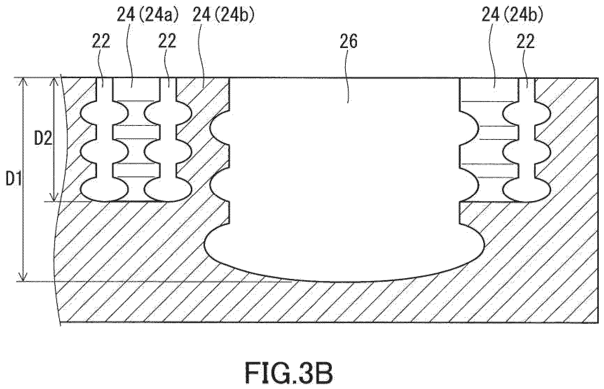

FIG. 3A is a cross-sectional view of the cell main body 10 taken along line IIIA-IIIA shown in FIG. 2, where the vapor generating portion 20 is enlarged as seen from the lateral direction. FIG. 3B is a cross-sectional view of the cell main body 10 taken along line IIIB-IIIB shown in FIG. 2. As shown in FIG. 3A, the width of each of the plurality of grooves 22 cyclically varies along a thickness direction DR of the cell main body 10. The thickness direction DR of the cell main body 10 is the direction from the first surface 10p toward the second surface 10q. The plurality of grooves 22 each have a portion larger in width than an opening width W of each of the plurality of grooves 22 in the first surface 10p. Specifically, the plurality of grooves 22 each include a plurality of first portions 22a and a plurality of second portions 22b. The first portion 22a is a portion having a long gap distance between the adjacent pillars 24. The second portion 22b is a portion having a short gap distance between the adjacent pillars 24. The first portion 22a and the second portion 22b are alternately provided from the first surface 10p toward the second surface 10q. A width W2 of the second portion 22b of the groove 22 is, for example, equal to the opening width W of the groove 22 in the first surface 10p. In the present embodiment, three stages of the first portions 22a are provided along the thickness direction DR. However, the number of the first portions 22a and the second portions 22b is not particularly limited.

In generating the solid raw material from the raw material solution of the metal vapor, the solid raw material tends to adhere to the fine structure defining the vapor generating portion 20 to remain in the vapor generating portion 20. Further, the fine structure of the vapor generating portion 20 increases the efficiency of a chemical reaction caused by heating of the solid raw material such as CsN₃. Owing to the combined effect of an increase in specific surface area and a prevention of scattering of the solid raw material during the thermal decomposition, it is possible to efficiently generate an alkali metal vapor even at a low temperature through the chemical reaction of the solid raw material.

The width W of the groove 22 in the first surface 10p is, for example, 1 µm or more and 100 µm or less. A width W1 of the first portion 22a of the groove 22 is, for example, 5 µm or more and 200 µm or less. The width W2 of the second portion 22b of the groove 22 is approximately equal to the width W of the groove 22 in the first surface 10p. The width W1 of the first portion 22a and the width W2 of the second portion 22b may gradually decrease from the first surface 10p toward the second surface 10q. The length of one side L of the pillar 24 in the first surface 10p is, for example, 50 µm or more and 500 µm or less.

The introduction port 26 is an opening portion for introducing the raw material solution of the metal vapor into the plurality of grooves 22. The introduction port 26 is a bottomed opening portion and communicates with the plurality of grooves 22. The introduction port 26 includes at least one of a structure lacking a portion of at least one pillar 24 selected from the plurality of pillars 24 and a structure lacking the entirety of at least one pillar 24 selected from the plurality of pillars 24. In the present embodiment, the introduction port 26 includes both of these structures. According to such a configuration, the introduction port 26 is less prone to become a dead space, and thus is advantageous in terms of the miniaturization of the metal-vapor-filled cell 100. Even in the case where a drop of the raw material solution is large relative to the width of the groove 22 and the drop is difficult to inject directly into the groove 22, the drop can still be injected into the introduction port 26. Consequently, the probability of contamination of the first surface 10p of the cell main body 10 by the raw material solution or the solid raw material can be reduced. When the first surface 10p is maintained clean, the first glass sheet 11 can be reliably bonded to the first surface 10p. For these reasons, it is possible to improve the stability of the performance of the metal-vapor-filled cell 100 while achieving the miniaturization thereof.

The structure lacking a portion of the pillar 24 can be fabricated by providing the introduction port 26 in a manner that chips away the portion of the pillar 24. In this case, the plurality of pillars 24 includes a first pillar 24a and a second pillar 24b. The first pillar 24a is the pillar having the largest area among the plurality of pillars 24 when the cell main body 10 is viewed in plan. In the present embodiment, the pillar 24 having a square shape in plan view is the first pillar 24a. The second pillar 24b is a pillar having a smaller area than the first pillar 24a. In the present embodiment, the second pillar 24b is a pillar adjacent to the introduction port 26. The second pillar 24b is fabricated as a result of the lack of a portion of the first pillar 24a.

The structure lacking the entirety of the pillar 24 can be fabricated by providing the introduction port 26 in a manner that chips away the entirety of the pillar 24. Alternatively, the structure can be fabricated by ensuring, in the vapor generating portion 20, a region where the pillar 24 is not present.

The structure of the second pillar 24b is not particularly limited. The second pillar 24b may be a short pillar fabricated by cutting away or breaking an upper surface portion of the first pillar 24a, a cut pillar fabricated by cutting away a side surface portion of the first pillar 24a, a thin pillar fabricated by cutting away a peripheral portion of the first pillar 24a, or a modified pillar that has any combination of these characteristics. These are collectively referred to as a lacking pillar. Further, when the entirety of the pillar 24 is lacking, the portion where the pillar 24 is no longer present is recognized as a relatively large space present among the groups of pillars in the vapor generating portion 20. Such a space is referred to as a pillar-lacking region. That is, the vapor generating portion 20 includes the lacking pillar and/or the pillar-lacking region.

The introduction port 26 may be surrounded by the plurality of pillars 24. According to such a configuration, the raw material solution can be delivered throughout the plurality of grooves 22, thereby enabling efficient generation of the solid raw material from the raw material solution. In this case, the amount of the raw material solution used can be reduced, further reducing the probability of contamination of the first surface 10p of the cell main body 10 by the raw material solution or the solid raw material.

The entirety of the introduction port 26 may fit within the region where the plurality of grooves 22 and the plurality of pillars 24 are provided. According to such a configuration, dead space is further less prone to be generated.

In the present embodiment, the cell main body 10 has a rectangular shape, specifically a square shape, in plan view. The vapor generating portion 20 is provided at at least one selected from the four corner portions of the cell main body 10. According to such a configuration, the amount of the raw material solution that is to be introduced into each vapor generating portion 20 is reduced. Consequently, the probability of contamination of the first surface 10p of the cell main body 10 by the raw material solution or the solid raw material can be reduced. Further, the four corner portions are inherently prone to become dead spaces. By providing the vapor generating portion 20 at at least one selected from the four corner portions, the dead space in the cell main body 10 can be sufficiently reduced. This is advantageous in terms of the miniaturization of the metal-vapor-filled cell 100. In the present embodiment, the vapor generating portion 20 is provided at each of the four corner portions of the cell main body 10. According to such a configuration, the above effect is further improved. Further, in the case where the vapor generating portion 20 is provided at each of the four corner portions, the metal-vapor-filled cell 100 has a highly symmetrical structure. This is advantageous in terms of suppressing deviation of the center of the optical axis and enables the stable implementation of the metal-vapor-filled cell 100 (e.g., implementation in an atomic clock).

In FIG. 1, the plurality of (four in the present embodiment) vapor generating portions 20 are independent of each other. Direct transfer of the raw material between the vapor generating portions 20 is not possible. The plurality of vapor generating portions 20 communicate with each other only through the microchannel 18 and the optical chamber 14. Even according to such a configuration, the amount of the raw material solution to be introduced into each vapor generating portion 20 is reduced, thereby achieving the effect described above. The reduction in the amount of the raw material solution used also reduces the cost of the metal-vapor-filled cell 100. Further, the amount of the solid raw material remaining in the cell main body 10 can also be reduced. This is advantageous also in terms of the stability of the performance of the metal-vapor-filled cell 100. It is also possible to employ an embodiment in which the plurality of vapor generating portions 20 are interconnected. In the case where the amounts of the raw material solution supplied to the vapor generating portions 20 are not uniform, the effect of equalizing the amounts can be expected.

The vapor generating portion 20 may be provided at only two or three corner portions selected from the four corner portions of the cell main body 10. For example, in the case where a structure other than the metal-vapor-filled cell 100 is fabricated into one or two specific corner portions selected from the four corner portions, the vapor generating portion 20 can be fabricated into the two or three corner portions other than the specific corner portions.

As shown in FIG. 3B, a depth D1 of the introduction port 26 may be greater than a depth D2 of the groove 22. In the case where the introduction port 26 is slightly deeper than the groove 22, the introduction port 26 can be easily fabricated. However, the depth D1 of the introduction port 26 may be equal to the depth D2 of the groove 22. The depth D1 of the introduction port 26 may be less than the depth D2 of the groove 22. According to these configurations, the raw material solution introduced into the introduction port 26 can move smoothly to the plurality of grooves 22.

The shape of the introduction port 26 is not particularly limited. The introduction port 26 may have the shape of a circle, an ellipse, or a polygon, such as a rectangle, in plan view. The introduction port 26 may have the shape of a circular column, an elliptical column, or a polygonal column. In the first surface 10p, the introduction port 26 has a smaller opening area than the optical chamber 14. Such a structure contributes to the miniaturization of the metal-vapor-filled cell 100. However, the sizes of the optical chamber 14 and the introduction port 26 are not particularly limited.

When the metal-vapor-filled cell 100 is viewed in plan, the opening area of the introduction port 26 is, for example, larger than the area of the pillar 24. When the introduction port 26 has a circular shape in plan view and the pillar 24 has a rectangular shape, such as a square, in plan view, the diameter of the introduction port 26 may be larger than the length of one side of the pillar 24. According to such a configuration, the raw material solution can be easily injected into the groove 22. For the same reason, the diameter of the introduction port 26 may be larger than the width W of the groove 22. In the case where the introduction port 26 has a shape other than a circle in plan view, the "diameter of the introduction port 26" means the diameter of a circle having an area equal to the area of the region defined by the contour of the introduction port 26 in plan view.

In the present embodiment, the introduction port 26 and the plurality of grooves 22 are open to only the first surface 10p. That is, the vapor generating portion 20 does not extend through the second surface 10q. According to such a configuration, the raw material solution can be easily supplied from the first surface 10p through the introduction port 26 to the groove 22.

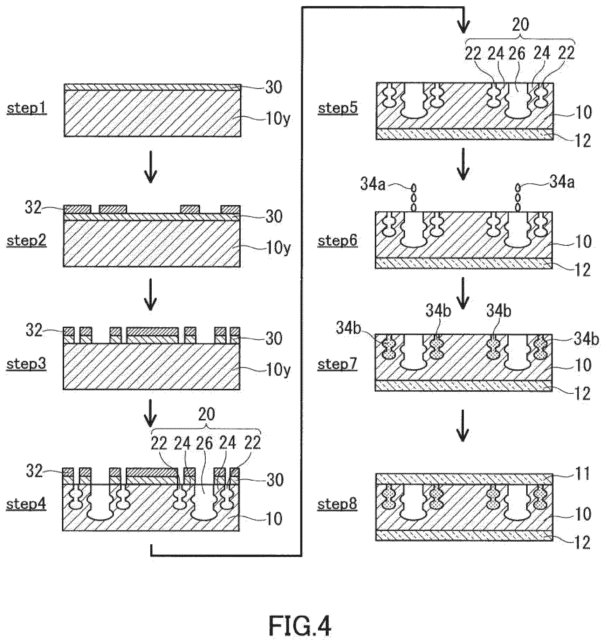

Next, a method for manufacturing the metal-vapor-filled cell 100 will be described. FIG. 4 is a process diagram showing a method for manufacturing the metal-vapor-filled cell 100.

As shown in step 1, a thin film 30 as the mask is formed on one surface of a substrate 10y. The thin film 30 may be a thin film of a metal such as Cr, Al, or Ni, or may be a silicon oxide film. The thin film 30 can be formed by a vapor phase method such as vapor deposition or sputtering. The substrate 10y is, for example, a silicon wafer. Since the plurality of metal-vapor-filled cells 100 can be manufactured from the one substrate 10y, the method of the present embodiment is excellent in productivity. The silicon wafer serving as the substrate 10y may be a polycrystalline wafer or a single-crystal wafer. Using the single-crystal wafer makes it possible to keep the internal atmosphere of the metal-vapor-filled cell 100 more stable and keep the vapor pressure of the alkali metal vapor more constant. No grain boundary in the single-crystal wafer facilitates the fabrication of the fine structure of the vapor generating portion 20 with high dimensional accuracy. The larger the size of the substrate 10y is, the more the mass production of the miniaturized metal-vapor-filled cell 100 can be performed.

Next, as shown in step 2, a resist 32 is applied onto the surface of the thin film 30 and the resist 32 is patterned by photolithography. The thin film 30 may be omitted to form the resist 32 directly on the substrate 10y.

Next, as shown in step 3, a portion of the thin film 30 is removed with an etchant to expose the surface of the substrate 10y.

Next, as shown in step 4, the optical chamber 14 (not shown in the figure) and the vapor generating portion 20 are fabricated by deep reactive ion etching. In the present embodiment, in preparing the cell main body 10, the optical chamber 14 and the vapor generating portion 20 are collectively fabricated by deep reactive ion etching. This makes it possible to manufacture the cell main body 10 with a small number of processes. In the case where the optical chamber 14 is provided in the first glass sheet 11 and/or the second glass sheet 12, the vapor generating portion 20 is fabricated in step 4. The microchannel 18 is fabricated in step 4 as well.

In the case where the optical chamber 14 and the vapor generating portion 20 are collectively fabricated, irregularities are provided not only in the vapor generating portion 20 but also on the inner peripheral surface of the optical chamber 14. In response to this, the following method is less prone to generate irregularities on the inner peripheral surface of the optical chamber 14, though including an increased number of processes. That is, the vapor generating portion 20 is fabricated by performing deep reactive ion etching from one surface (first surface) of the substrate 10y. The optical chamber 14 is fabricated by performing deep reactive ion etching from the other surface (second surface) of the substrate 10y. By simply digging into the substrate 10y, it is possible to form, as the optical chamber 14, a through hole having a flat inner peripheral surface.

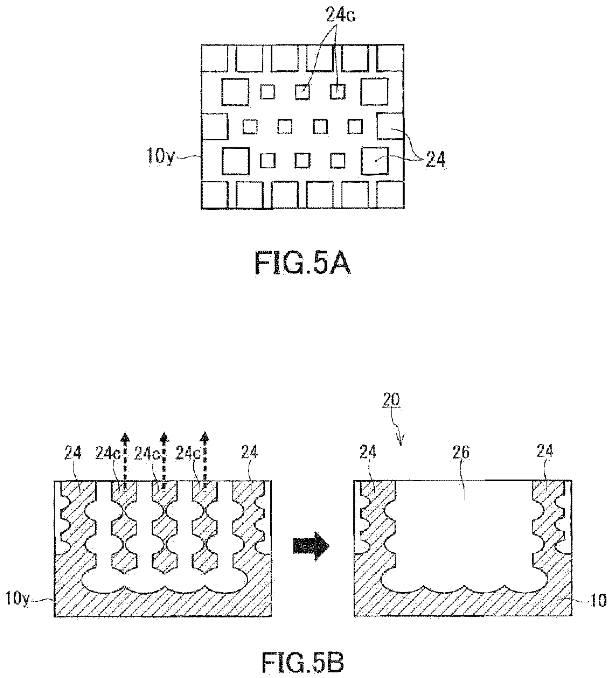

FIG. 5A and FIG. 5B are views for illustrating a method for fabricating the introduction port 26. FIG. 5A is a plan view of the substrate 10y. FIG. 5B is a cross-sectional view of the substrate 10y. As shown in FIG. 5A, the resist 32 is patterned so that a plurality of thin pillars 24c are positioned in a predetermined region, and the groove 22 is fabricated by deep reactive ion etching. The predetermined region is a region where the introduction port 26 is to be fabricated. The number of the thin pillars 24c may be one. Next, as shown in FIG. 5B, at the deepest position of the groove 22, the substrate 10y is extensively etched in the horizontal direction. Thus, the thin pillar 24c is removed and the introduction port 26 is fabricated in the predetermined region.

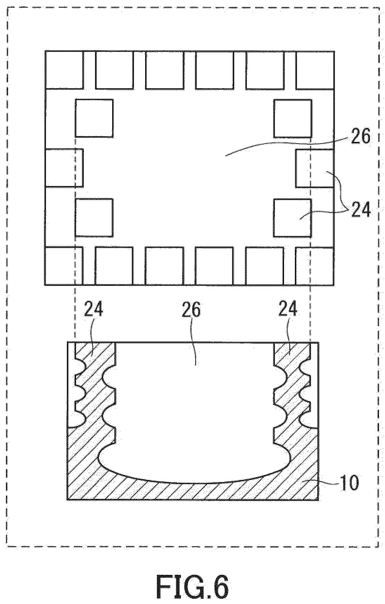

FIG. 6 is a plan view and a cross-sectional view, both illustrating another method for fabricating the introduction port 26. In this example, no pattern of the pillar 24 is drawn in the predetermined region corresponding to the introduction port 26. The introduction port 26 can be fabricated by deep reactive ion etching.

The method for fabricating the vapor generating portion 20 by deep reactive ion etching is described in detail in Patent Literature 2, and those descriptions are incorporated herein by reference.

After the end of the deep reactive ion etching, the thin film 30 and the resist 32 are removed to obtain the cell main body 10.

Next, as shown in step 5, the second glass sheet 12 is bonded to the second surface 10q of the cell main body 10. This covers the second surface 10q side of the optical chamber 14. The method for bonding the second glass sheet 12 and the cell main body 10 to each other is anodic bonding. In anodic bonding, the second glass sheet 12 and the cell main body 10 are overlaid on each other, and a direct-current voltage is applied between them while heating them. The heating temperature is, for example, 150°C or higher and 600°C or lower. The applied voltage is, for example, 200 V or higher and 1200 V or lower. In the case where the optical chamber 14 is a bottomed hole, the second glass sheet 12 is unnecessary and step 5 is omitted.

Next, as shown in step 6, a raw material solution 34a of the metal vapor is injected into the introduction port 26 to introduce the raw material solution 34a into the groove 22. The raw material solution 34a is supplied to the groove 22 by capillary action.

Since the introduction port 26 is open to the first surface 10p, the injection of the raw material solution 34a is also performed from the first surface 10p. The injection is performed using equipment or devices suitable for injecting liquid into a microregion. Examples of such equipment or devices include micropipettes and inkjet systems. For example, by recognizing at least one of the groove 22, the pillar 24, and the introduction port 26 through image processing, the injection of the raw material solution 34a can be performed automatically using the above equipment or devices. Alternatively, in the case where alignment marks are provided on a silicon wafer into which the cell main body 10 is fabricated, such alignment marks may be used to align the above equipment or devices.

Next, in step 7, the solvent contained in the raw material solution 34a is evaporated to deposit a solid raw material 34b of the metal vapor on the surface of the pillar 24. Specifically, the solvent is evaporated by heating the cell main body 10. The heating of the cell main body 10 can be achieved by placing the cell main body 10 on a hot plate or processing the cell main body 10 in a heating furnace.

The raw material solution 34a is a solution containing a metal compound. Examples of the metal compound include a metal azide such as CsN₃ and a metal halide such as CsCl. The metal compound is typically an alkali metal compound. In the present embodiment, an alkali metal vapor is generated by using a chemical reaction of an alkali metal compound. For example, when the alkali metal is Cs, a CsN₃ solution is introduced into the vapor generating portion 20 of the cell main body 10 to deposit solid CsN₃. The solvent in the CsN₃ solution may be an inorganic solvent such as water, or may be an organic solvent such as alcohol, acetone, or acetonitrile.

The heating temperature for the cell main body 10 for depositing the solid raw material 34b on the surface of the pillar 24 is, for example, 25°C or higher and 315°C or lower. The "heating temperature" is the temperature of the surroundings where the cell main body 10 is placed. In the case where a hot plate is used, the heating temperature is the surface temperature of the hot plate. In the case where a heating furnace is used, the heating temperature is the temperature inside the heating furnace.

After the deposition of the solid raw material 34b, degassing of the solid raw material 34b and the cell main body 10 may be performed in a vacuum atmosphere. According to the present embodiment, since the vapor generating portion 20 is open to the first surface 10p, efficient degassing can be performed.

Next, in step 8, the first glass sheet 11 is bonded to the first surface 10p of the cell main body 10. The method for bonding the first glass sheet 11 and the cell main body 10 to each other is anodic bonding as well. In anodic bonding, the first glass sheet 11 and the cell main body 10 are overlaid on each other, and a direct-current voltage is applied between them while heating them. The heating temperature is, for example, 150°C or higher and 300°C or lower. The applied voltage is, for example, 200 V or higher and 1200 V or lower. The process in step 8 is performed in a vacuum or in an atmosphere of an inert gas such as a noble gas or N₂ gas. The degree of vacuum is, for example, 1 × 10⁻³ Pa or higher and 1 × 10⁻⁷ Pa or lower. The atmosphere for performing the process in step 8 is determined based on the amount of the solid raw material 34b in the cell main body 10 and the amount of the buffer gas in the cell main body 10 that are both anticipated to be present after the bonding of the first glass sheet 11 to the cell main body 10.

By bonding the first glass sheet 11 and the cell main body 10 to each other, not only the first surface 10p of the cell main body 10 except a portion corresponding to the vapor generating portion 20 but also the upper surfaces of the plurality of pillars 24 of the vapor generating portion 20 are bonded to the first glass sheet 11. The first glass sheet 11 may match the first surface 10p of the cell main body 10 in terms of dimensions in plan view. The second glass sheet 12 may match the second surface 10q of the cell main body 10 in terms of dimensions in plan view.

After the bonding of the first glass sheet 11 to the cell main body 10, the metal vapor is generated from the solid raw material 34b, and the metal vapor is introduced into the optical chamber 14. Specifically, the metal vapor is generated from the solid raw material 34b by heating the cell main body 10. The heating of the cell main body 10 can be achieved by placing the cell main body 10 on a hot plate or treating the cell main body 10 in a heating furnace. The heating temperature for the cell main body 10 for generating the metal vapor is, for example, 250°C or higher and 400°C or lower. Note that instead of by heating the cell main body 10, the metal vapor may be generated by decomposing the solid raw material 34b through UV light irradiation, or the metal vapor may be generated by decomposing the solid raw material 34b through laser light irradiation.

When solid CsN₃ is heated in a vacuum, Cs and N₂ are generated according to the following chemical reaction. The method for generating an alkali metal by thermal decomposition of a metal azide has the advantage of being capable of simultaneously generating an alkali metal vapor and N₂ gas as the buffer gas to fill the cell main body 10 without generating any product which would exert influence on the performance such as the gas pressure inside the metal-vapor-filled cell 100. The above method also has the advantage of generating no by-product except an alkali metal and N₂ and thus causing no influence of the by-product on the gas pressure and its fluctuations.

2CsN₃ → 2Cs+3N₂ ... (1)

The alkali metal compound is not limited to a metal azide. For example, as shown in the following formula (2), Cs vapor can be generated by reacting CsCl and BaN₆ with each other.

BaN₆+2CsCl → 2Cs+BaCl₂+3N₂ ... (2)

Through the above processes, the metal-vapor-filled cell 100 of the present embodiment is obtained. A portion of the solid raw material 34b remains undecomposed in the vapor generating portion 20. That is, the metal-vapor-filled cell 100 has the solid raw material 34b of the metal vapor, where the solid raw material 34b is adherent to the vapor generating portion 20. According to the present embodiment, neither member nor material except the solid raw material 34b is present inside the metal-vapor-filled cell 100. This makes it possible to keep the internal atmosphere of the metal-vapor-filled cell 100 stable and keep the vapor pressure of the alkali metal vapor constant. Owing to the solid raw material 34b remaining in the vapor generating portion 20, in the case where the vapor pressure of the metal vapor in the optical chamber 14 decreases due to the deterioration over time, it is also possible to compensate for the metal vapor by reheating the metal-vapor-filled cell 100.

The metal-vapor-filled cell 100 of the present embodiment contains the metal vapor of a predetermined concentration generated inside the optical chamber 14 under the operating environment (e.g., for Cs vapor, approximately 80°C). Accordingly, the respective required sizes of the optical chamber 14 and the vapor generating portion 20 are interrelated. Further, the required size varies depending also on the type of metal vapor. Additionally, the strength and durability achieved by closely adhering the first glass sheet 11 and the second glass sheet 12 to the cell main body 10 are also influenced by the areas of the adhesive surfaces between these glass sheets 11 and 12 and the cell main body 10. In consideration of these conditions, the size of the cell main body 10 and the size of each portion are designed.

Some modifications will be described below. The elements common to the embodiment and the modifications are denoted by the same reference numerals, and the descriptions thereof may be omitted. The descriptions on the embodiment and the modifications can be applied to each other unless they are technically contradictory. The embodiment and the modifications may be combined with each other unless they are technically contradictory.

### (Modifications)

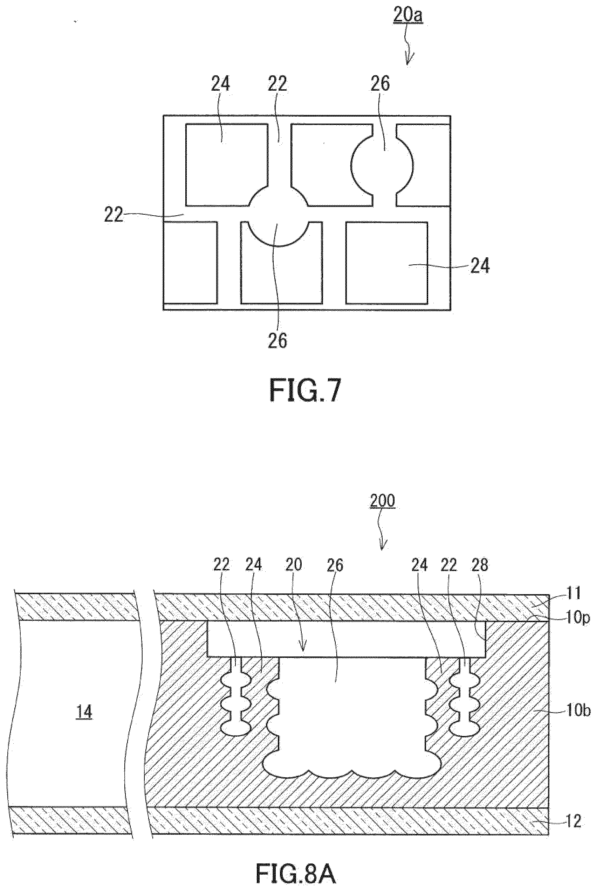

FIG. 7 is a plan view of a vapor generating portion 20a according to Modification 1. The vapor generating portion 20a can be applied to the metal-vapor-filled cell 100 shown in FIG. 1 and FIG. 2. In the present modification, when the metal-vapor-filled cell 100 is viewed in plan, the opening area of the introduction port 26 is smaller than the area of the pillar 24. When the introduction port 26 has a circular shape in plan view and the pillar 24 has a rectangular shape, such as a square, in plan view, the diameter of the introduction port 26 may be smaller than the length of one side of the pillar 24. According to such a configuration, the first surface 10p is less prone to become contaminated during the generation of the solid raw material from the raw material solution.

In the present modification, the plurality of pillars 24 are arranged in a staggered pattern. The introduction port 26 is fabricated across the plurality (e.g., two or three) of pillars 24. In one example, the plurality of grooves 22 include T-shaped portions. The center of the introduction port 26 is positioned at the T-shaped portion of the groove 22. That is, the introduction port 26 is fabricated across the three pillars 24.

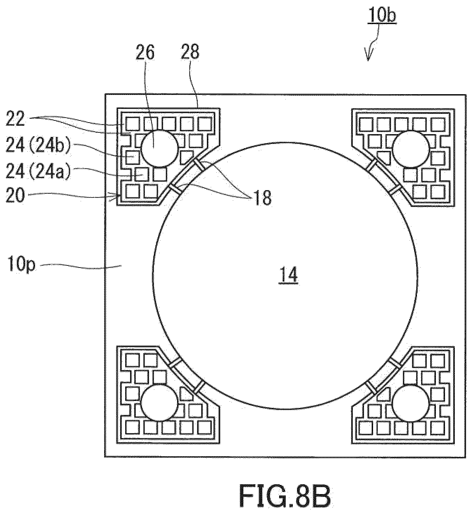

FIG. 8A is a cross-sectional view of a metal-vapor-filled cell 200 using a cell main body 10b according to Modification 2. FIG. 8B is a plan view of the cell main body 10b according to Modification 2. The metal-vapor-filled cell 200 includes the cell main body 10b having a step 28. The step 28 is provided on the first surface 10p so as to surround the vapor generating portion 20. According to such a configuration, the first surface 10p is less prone to become contaminated by the raw material solution and the solid raw material around the step 28. Therefore, the first glass sheet 11 can be reliably bonded to the first surface 10p of the cell main body 10b.

The groove 22 and the introduction port 26 are open to the bottom surface of the recess generated by the step 28. The first glass sheet 11 is bonded to the first surface 10p around the step 28. A space having a height corresponding to the step 28 is present between the first glass sheet 11 and the vapor generating portion 20.

The step 28 may be provided only around the vapor generating portion 20. The optical chamber 14 is not surrounded by the step 28. Specifically, when the cell main body 10b is viewed in plan, the step 28 is present at 360° around the vapor generating portion 20, while a line segment can be present that connects the outer edge of the cell main body 10b and the optical chamber 14 without intersecting the step 28. According to such a configuration, the bonding between the first glass sheet 11 and the first surface 10p can be reliably achieved. Consequently, the stability of the performance of the metal-vapor-filled cell 200 is improved.

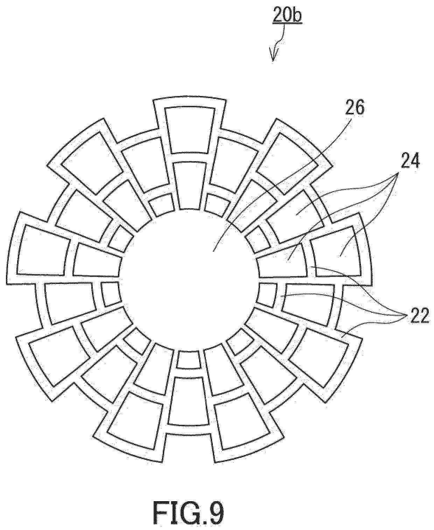

FIG. 9 is a plan view of a vapor generating portion 20b according to Modification 3. The plurality of pillars 24 are arranged in a radial pattern. In the central portion of the vapor generating portion 20b, no pillar 24 is provided and the introduction port 26 is provided. Each pillar 24 is not rectangular in plan view and also has a different size. According to the vapor generating portion 20, the structure is isotropic in all directions as viewed from the introduction port 26. Consequently, the solid raw material can be uniformly supplied to each pillar 24. The plurality of pillars 24 may be arranged in a spiral pattern. A spiral arrangement is an arrangement obtained by twisting a radial arrangement. In Modification 3, since the introduction port 26 is present at the central portion of the radial arrangement, the position where the solution is to be introduced can be easily identified.

In FIG. 9, the plurality of pillars 24 are symmetrically arranged over 360 degrees around the introduction port 26. However, the plurality of pillars 24 may be arranged only within a 180-degree range around the introduction port 26. A plurality of structures each having the plurality of pillars 24 arranged within a 60-degree range may be provided around the introduction port 26. The pillar 24 can be appropriately arranged depending on the purpose. Naturally, these arrangements may be used in combination with other arrangements.

In the present invention, the size of the pillar, the arrangement of the pillar, the arrangement of the introduction port, and the size of the introduction port are not limited to those described in the embodiments and modifications. For example, although not shown in the figure, the pillar having a large size in plan view may be arranged only around the introduction port for the purpose of preventing accidental leakage of the raw material solution or preventing scattering during solvent evaporation.

As long as the introduction port 26 is provided within the region where the plurality of grooves 22 and the plurality of pillars 24 are positioned in plan view, it is not required that the introduction port 26 be open to only the first surface 10p. The introduction port 26 may be a bottomed hole that is open to only the second surface 10q.

It is not required that the optical chamber be provided only in the cell main body. For example, the optical chamber may be composed of the first glass sheet having a recess provided at a predetermined position and the cell main body. The optical chamber may be composed of only the recess in the first glass sheet. Additionally, on the second surface side, which is the opposite side from the first surface side where the vapor generating portion is open, the optical chamber may be provided in the second glass sheet. In this case, the vapor generating portion and the optical chamber are connected by a microchannel (communicating hole) that extends through the cell main body. Thus, it is possible to select a design suitable for the use of the metal-vapor-filled cell. The recess in the glass sheet can be fabricated by etching or other methods.

### INDUSTRIAL APPLICABILITY

The metal-vapor-filled cell of the present invention is useful for atomic clocks, magnetic sensors, inertial sensors, and the like.

## Claims

1. A metal-vapor-filled cell comprising:
a cell main body comprising a first surface and a vapor generating portion;
a glass sheet bonded to the first surface of the cell main body;
an optical chamber provided in at least one selected from the cell main body and the glass sheet, the optical chamber communicating with the vapor generating portion; and
a metal vapor filling the optical chamber, wherein
the vapor generating portion comprises a plurality of pillars, a plurality of bottomed grooves provided between the plurality of pillars and open to the first surface, and an introduction port for introducing a raw material solution of the metal vapor into the plurality of bottomed grooves, and
the introduction port comprises at least one of a structure lacking a portion of at least one pillar selected from the plurality of pillars and a structure lacking the entirety of at least one pillar selected from the plurality of pillars.

2. The metal-vapor-filled cell according to claim 1, wherein
the introduction port is surrounded by the plurality of pillars.

3. The metal-vapor-filled cell according to claim 1, wherein
the cell main body has a rectangular shape in plan view, and
the vapor generating portion is provided at at least two selected from four corner portions of the cell main body.

4. The metal-vapor-filled cell according to claim 1, wherein
the optical chamber is provided in the cell main body.

5. The metal-vapor-filled cell according to claim 1, wherein
the cell main body further comprises a step, the step being provided on the first surface so as to surround the vapor generating portion.

6. The metal-vapor-filled cell according to claim 1, wherein
when the metal-vapor-filled cell is viewed in plan, an opening area of the introduction port is larger than an area of the pillar.

7. The metal-vapor-filled cell according to claim 1, wherein
the introduction port and the plurality of bottomed grooves are open to only the first surface.

8. The metal-vapor-filled cell according to claim 1, wherein
the cell main body further comprises a second surface,
the optical chamber comprises a through hole extending through the cell main body from the first surface to the second surface, and
no through hole is present other than the through hole serving as the optical chamber.

9. The metal-vapor-filled cell according to claim 1, wherein
the cell main body further comprises a second surface,
a first glass sheet is bonded to the first surface,
a second glass sheet is bonded to the second surface, and
the optical chamber is provided in at least one selected from the group consisting of the cell main body, the first glass sheet, and the second glass sheet.
